# EUROPÄISCHE PATENTANMELDUNG

(11) **EP 1 275 751 A1**
(43) Veröffentlichungstag der Anmeldung: **15.01.2003**
(21) Anmeldenummer: 01810698.9
(22) Anmeldetag: 13.07.2001
(51) Int. Cl.: C23C 14/50, C23C 14/56, C23C 14/06, C23C 14/08, G02B 1/10

(54) **Verfahren und Vorrichtung zur Herstellung eines optisch wirksamen Schichtsystems**

(71) Anmelder: Satis Vacuum Industries Vertriebs - AG, 6341 Baar (CH)
(72) Erfinder: Breme, Frank, 8915 Hausen am Albis (CH)
(74) Vertreter: Patentanwälte Schaad, Balass, Menzl & Partner AG

(57) **Zusammenfassung**

Die Erfindung betrifft ein Verfahren und eine Vorrichtung zur Herstellung eines optisch wirksamen Schichtsystems (3) auf einem Substrat (1) mit einer Vorderseite (1a) und einer Rückseite (1b) durch plasmaunterstütztes Zerstäuben eines Festkörpertargets (Sputtern). Zur Verminderung der Rückseitenbeschädigung wird vor dem Abscheiden des Schichtsystems (3) auf der Vorderseite (1a) des Substrats auf dessen Rückseite (1b) eine Schutzschicht (2) aufgesputtert.

## Beschreibung

Die Erfindung betrifft ein Verfahren zur Herstellung eines optisch wirksamen Schichtsystems mit den Merkmalen von Anspruch 1 sowie eine Vorrichtung zur Durchführung des Verfahrens mit den Merkmalen von Anspruch 10.

Zum Herstellen eines optischen Elements mit definierten optischen Eigenschaften ist es bekannt, ein Substrat in vorbestimmter Weise mit einem Schichtsystem aus mehreren Schichten mit unterschiedlichen optischen Eigenschaften, insbesondere unterschiedlicher Brechzahl, zu versehen. Abhängig vom Aufbau des Schichtsystems kann beispielsweise die Reflexion oder Transmission in bestimmten Wellenlängenbereichen weitgehend unterdrückt werden. Solche Schichtsysteme werden beispielsweise als Antireflexbeschichtung bei Brillengläsern oder für optische Filter oder Spiegel verwendet. Übliche Schichtmaterialien sind insbesondere Dielektrika wie Siliziumoxid oder Siliziumnitrid. Beispiele für den Aufbau von Antireflexbeschichtungen für Brillengläser sind beispielsweise in H. Pulker, Optical Coatings on Glass, 2^{nd} edition, Elsevier, Amsterdam 1999 beschrieben. Zur Herstellung eines optischen Elements mit hoher Qualität müssen die einzelnen Schichten des Schichtsystems über die gesamte Substratfläche eine vorbestimmte Dicke aufweisen. Des weiteren muss das Substrat eine vorbestimmte Oberflächenstruktur haben.

Zur Herstellung von dünnen Schichten werden beispielsweise Sputterverfahren eingesetzt. Ein Festkörpertarget wird durch einen Ionenstrahl oder in einem Plasma mit Ionen beschossen, wodurch einzelne Atome aus dem Target gelöst werden und sich auf dem Substrat ablagern. Zur Herstellung optischer Beschichtungen ist dem Sputter-Gas, z.B. Argon, häufig ein reaktives Gas beigefügt, z.B. Sauerstoff oder Stickstoff, mit dem die sich ablagernden Atome reagieren. Es ist beispielsweise aus M. Ruske et al., Properties of SiO2 and Si3N4 layers deposited by MF twin magnetron sputtering using different target materials, Thin Solid Films 351 (1999) 158-163 bekannt, mit einem einzigen Targetmaterial durch Zusatz von beispielsweise Sauerstoff oder Stickstoff als reaktivem Gas optische Schichten unterschiedlicher Zusammensetzung herzustellen, z.B. SiO₂ und Si₃N₄. Beim Sputtern kann nur die dem Target zugewandte Seite beschichtet werden. Bei einem beidseitig zu beschichtenden Substrat, z.B. einem Brillenglas, wird das Substrat daher nach der Beschichtung der Vorderseite gewendet, um die Rückseite zu beschichten.

Problematisch bei plasmagestützen Sputterverfahren zur Herstellung von optischen Schichtsystemen auf einem Substrat ist die sogenannte Rückseitenbelastung,d.h. eine Beschädigung durch z.B. Materialabtrag, Zersetzung, Kontamination und dergleichen. Während des Beschichtens einer Seite erfährt die andere Seite des Substrats durch das umgebende Plasma unerwünschte Veränderungen. Insbesondere sauerstoffhaltige Plasmen beschädigen die Substratoberfläche. Sauerstoffhaltige Plasmen werden bei allen gängigen reaktiven Sputterverfahren für die Abscheidung zumindest eines Schichtmaterials eingesetzt, z.B. von SiO₂. Die Rückseitenbelastung ist kritisch bei optischen Elementen, bei denen Vorder- und Rückseite mit einem wohldefinierten Schichtsystem versehen werden müssen. Auch kann die Oberflächenveränderung dazu führen, dass die aufgebrachte Beschichtung nicht dauerhaft haftet.

Zum Schutz der abgewandten Seite vor unerwünschten Ablagerungen ist es bekannt, das Substrat möglichst passgenau in einen Substrathalter einzusetzen, so dass die abgewandte Seite nicht in Kontakt mit dem Plasma bzw. dem Targetmaterial kommt. Dazu wird die Kontur des Substrathalters so an die Form der Oberfläche des Substrats angepasst, dass ein gegenseitiger Abstand von höchstens 2 mm (Dunkelraumabstand) besteht und sich in diesem Bereich kein Plasma bilden kann. Da die Krümmungen von ophthalmischen Linsen stark variieren, ist eine grosse Anzahl von verschiedenen Substrathaltern notwendig, die vor jedem Beschickungsvorgang überprüft und gegebenenfalls gewechselt werden müssen.

Aus der US 6 143 143 ist bekannt, die jeweils nicht besputterte Seite eines optischen Glases durch mechanische Mittel vor unerwünschten Ablagerungen zu schützen. Dazu wird vorgeschlagen, die der zu besputternden Seite abgewandte Seite entweder durch Aufkleben einer Membran oder durch Auftragen eines schützenden Gels oder Sprays zu bedecken. Als weitere Lösung wird ein Substrathalter aus einem elastischen Material vorgeschlagen, z.B. Schaumstoff oder Neopren, der sich an das Substrat anschmiegt. Nachteilig hierbei ist der hohe Aufwand, das Material aufzubringen und anschliessend zum Beschichten der anderen Seite wieder zu entfernen. Die Sputterkammer muss dazu während des Prozesses belüftet werden. Des weiteren kann Material wie die aufgeklebte Membran die Reaktionsbedingungen in der Sputterkammer stören und zu unerwünschten Ablagerungen oder Veränderungen in der Struktur der Schichten führen.

Der Erfindung liegt daher die Aufgabe zugrunde, ein plasmagestütztes Sputterverfahren zur Herstellung eines optisch wirksamen Schichtsystems auf einem flächigen Substrat anzugeben, bei welchem Beeinträchtigungen der Rückseite des Substrats bzw. des darauf abgeschiedenen Schichtsystems weitgehend vermieden werden. Des weiteren soll eine Vorrichtung zur Durchführung des Verfahrens zur Verfügung gestellt werden.

Die Aufgabe wird gelöst durch ein Verfahren mit den Merkmalen von Anspruch 1 sowie durch eine Vorrichtung mit den Merkmalen von Anspruch 10. Vorteilhafte Weiterbildungen des Verfahrens und der Vorrichtung sind in den abhängigen Ansprüche, der Beschreibung und den Zeichnungen beschrieben.

Bei einem plasmaunterstützten Sputterverfahren zur Herstellung eines optisch wirksamen Schichtsystems auf einem Substrat mit einer Vorderseite und einer Rückseite, insbesondere einem flächigen, transparenten Substrat, z.B. einem optischen Element aus Kunststoff oder Glas, wird erfindungsgemäss vor dem Beschichten der Vorderseite auf der Rückseite des Substrats eine Schutzschicht aufgesputtert. Das Substrat wird anschliessend zum Besputtern der Vorderseite gewendet. Nach Herstellung des Schichtsystems auf der Vorderseite wird das Substrat gegebenenfalls wieder gewendet, um ein weiteres Schichtsystem auf der Rückseite abzuscheiden. Die Schutzschicht schützt das Substrat vor unerwünschten Veränderungen durch die reaktive Atmosphäre während des Beschichtens des Vorderseite. Die Prozessbedingungen bei der Herstellung der Schutzschicht bzw. ihre Dicke und ihr Material werden so gewählt, dass die Vorderseite des Substrats durch die Herstellung der Schutzschicht nicht beeinträchtigt wird, jedoch eine ausreichende Schutzwirkung gegeben ist, indem während der Beschichtung der Vorderseite höchstens die Schutzschicht, nicht aber das Substrat abgetragen wird. Die erste Bedingung wird vorzugsweise erfüllt, indem die Schutzschicht in einem stickstoffhaltigen Plasma abgeschieden wird und beispielsweise aus Siliziumnitrid Si_{X}N_{Y} besteht. Gegebenenfalls kann auch ein Sauerstoffplasma zum Einsatz kommen, da die Belastung der Vorderseite durch Geringhalten der Abscheidedauer und/oder durch erhöhte Abscheidedrücke kontrollierbar ist. Bevorzugt ist eine maximale Dicke von etwa 40 µm. Die zweite Bedingung wird beispielsweise dadurch erfüllt, dass die Schutzschicht eine minimale Dicke von etwa 10 µm aufweist.

Die Schutzschicht besteht beispielsweise aus Siliziumoxid, Siliziumnitrid, Aluminiumoxid und/oder Aluminiumnitrid. Diese Materialien haben den Vorteil, dass die Schutzschicht und die weiteren hoch- und niedrigbrechenden Schichten des Schichtsystems mit einem einzigen silizium- bzw. aluminiumhaltigen Target herstellbar sind. Wenn mit unterschiedlichen Targets gearbeitet wird, kommt für die Schutzschicht grundsätzlich die erste Schicht des auf der Rückseite anzubringenden weiteren Schichtsystems in Frage, beispielsweise die gängigen hochbrechenden Materialien Titanoxid TiO₂, Zirkonoxid ZrO₂, Tantalumpentaoxid Ta₂O₅.

Bei Beschichtung beider Substratseiten dient die Schutzschicht in einer vorteilhaften Weiterbildung des Verfahrens als erste Schicht des auf der Rückseite aufzutragenden Schichtsystems. Die Herstellungsbedingungen werden so gewählt, dass die optischen Eigenschaften der Schutzschicht nach Erfüllen der Schutzfunktion an die durch das weitere Schichtsystem zu erfüllenden Vorgaben angepasst sind. Dabei wird der Materialverlust während der Vorderseiten-Beschichtung gegebenenfalls eingerechnet. Insbesondere bei Antireflex-Beschichtungen besteht die unterste Schicht üblicherweise aus Siliziumnitrid Si₃N₄ und kann die Funktion der Schutzschicht übernehmen.

Besonders einfach ist die Durchführung des Verfahrens, wenn die Schutzschicht unter Verwendung desselben Targets hergestellt wird, das auch zur Herstellung wenigstens einzelner, vorzugsweise aller Schichten des Schichtsystems dient. In diesem Fall kann die vollständige Beschichtung einschliesslich der Schutzschicht ohne Austausch des Targets aufgesputtert werden. Die verschieden brechenden Materialien der einzelnen Schichten können durch Austausch der reaktiven Gase realisiert werden. Beispielsweise wird ein reines Silizium- oder ein Silizium-Aluminium-Target in wechselweise O₂- und N₂-haltigem Plasma eingesetzt.

Die erfindungsgemässe Vorrichtung zur Durchführung des Verfahrens umfasst eine evakuierbare Sputterkammer und einen Substrathalter mit drehbaren Aufnahmeelementen für Substrate, mit denen die Substrate sowohl um eine im wesentlichen parallel zur Substratfläche orientierte Wendeachse als auch um eine im wesentlichen senkrecht zur Substratfläche orientierte Drehachse drehbar sind. Bei einem kreisförmigen konkaven oder konvexen Substrat ist die Drehachse beispielsweise die durch den Scheitelpunkt laufende Flächennormale und die Wendeachse eine Senkrechte dazu. Durch die erfindungsgemässe Vorrichtung kann bei ortsfestem Target durch Wenden des Substrats wahlweise die Vorderseite oder die Rückseite der Substrate besputtert werden kann, ohne die Sputterkammer zu öffnen. Die Drehbewegung dient zur Erzeugung einer homogenen und gleichmässigen Schichtdickenverteilung. Besonders bevorzugt werden beide Bewegungen mit demselben Antrieb realisiert.

Ausführungsbeispiele der Erfindung sind in den Zeichnungen dargestellt, wobei rein schematisch zeigen:
- Fig. 1A-E: die einzelnen Verfahrensschritte beim Beschichten von Vorder- und Rückseite eines Substrats;
- Fig. 2: ein erfindungsgemässer Substrathalter in 3D-Ansicht in Arbeitsposition (Beschichten);
- Fig. 3: der Substrathalter gemäss Fig. 2 in Wendeposition;
- Fig. 4: den Substrathalter aus Fig. 2 im Längsschnitt in Arbeitsposition;
- Fug. 5: den Substrathalter aus Fig. 2 im Längsschnitt in Wendeposition.

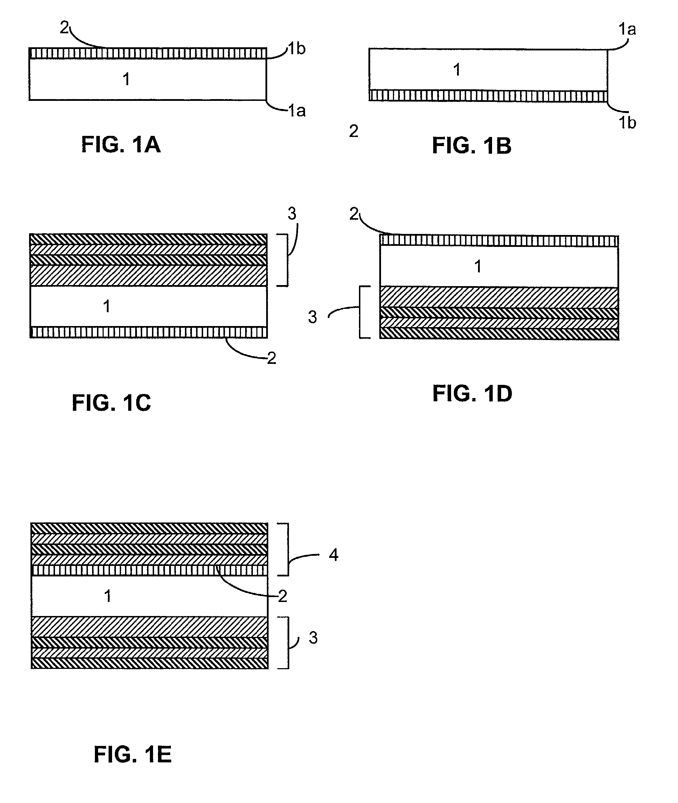

Anhand von Fig. 1A-E wird im folgenden ein Verfahrensbeispiel für die Beschichtung von flächigen, transparenten Substraten 1, insbesondere Brillengläsern, mit einer Antireflex-Schicht 3, 4 auf der Vorderseite 1a und der Rückseite 1b beschrieben. Die in den Figuren gezeigten Abmessungen sind rein schematisch; auch ist die häufig vorhandene Krümmung des Substrats 1 nicht gezeigt.

Typische Gasflüsse liegen im Bereich von beispielsweise 2 bis 50 sccm (Standard-Kubikzentimeter), können je nach Anwendungsfall und eingesetzter Pumpe auch kleiner oder grösser sein. Der daraus resultierende Druck in der Beschichtungskammer liegt im Bereich 5·10⁻² bis 8·10⁻⁴ mbar.

Die Plasmaleistung beträgt beispielsweise etwa 1,0 - 2,5 KW.

Als Sputterverfahren wird das gepulste DC-Sputtern eingesetzt. Dabei wird das Plasma mit einem Elektronen-Gleichstrom erzeugt, der mit einer bestimmten Frequenz ein- und ausgeschaltet wird. Während einer Periode ist das Plasma jeweils für eine bestimmte Zeit (Pulse pause time PPT) ausgeschaltet.

Die einzelnen Schichten der Schichtsysteme 3, 4 werden jeweils nach folgendem Schema abgeschieden: Zunächst werden die Gasflüsse eingestellt. Nach einer kurzen Wartezeit, z.B. 10 s, wird das Plasma gezündet. Ein Shutter zwischen Target und Substrat 1 wird nach einer zur Plasmastabilisierung genutzten weiteren Wartezeit, z.B. 10 s, für die vorgegebene Beschichtungsdauer geöffnet und anschliessend geschlossen.

Zuerst wird die konkave Seite 1b mit einer erfindungsgemässen Schutzschicht 2 aus Si_{X}N_{Y} besputtert. Dazu werden beispielsweise folgende Prozessparameter gewählt:
10 sccm Ar₂, 30 sccm N₂, Leistung: 1750 W, Frequenz: 90 kHz, Pulse reverse time (PPT): 5 µs. Bei einer Beschichtungsdauer von 22 s wird eine 15 nm dicken Si_{X}N_{Y}-Schicht 2 abgeschieden (Fig. 1A).

Anschliessend wird das Substrat 1 gewendet (Fig. 1B) und die konvexe Seite 1a in an sich bekannter Weise mit einem Antireflex-Schichtsystem 3 beschichtet, das hier aus vier Schichten besteht (Fig. 1C). Ein typisches Schichtsystem umfasst von innen nach aussen beispielsweise 35 nm Si_{X}N_{Y}, 20 nm SiO₂, 61 nm Si_{X}N_{Y}, 92 nm SiO₂.

Für die Si_{X}N_{Y}-Schichten werden die Prozessparameter mit Ausnahme der Beschichtungsdauer beispielsweise entsprechend der Parameter für die Herstellung der Schutzschicht gewählt.

Für die SiO₂-Schichten werden beispielsweise folgende Parameter gewählt: 10 sccm Ar₂, 25 sccm O₂; 1750 W, 90 kHz, 5 µs PPT

Die Beschichtungszeiten (Shutter in der Stellung "offen") betragen für die Schichten von innen nach aussen beispielsweise: 1. 41 s, 2. 25 s, 3. 72 s, 4. 115 s.

Nach dem Abscheiden des vollständigen Schichtsystems auf der konvexen Seite wird das Substrat erneut gewendet (Fig. 1D) und die konkaven Seite 1b mit dem restlichen Antireflex-Schichtsystem 4 beschichtet (Fig. 1E), das mit dem Schichtsystem 3 der konvexen Seite 1a identisch ist. Von der Schutzschicht wurden durch die Rückseitenbelastung des Plasmas etwa 5 nm abgetragen, so dass noch 10 nm Si_{X}N_{Y} verbleiben (Dickenverlust nicht dargestellt). Es werden damit als erste Schicht 25 nm Si_{X}N_{Y} abgeschieden, dann folgen wie beschrieben die übrigen drei Schichten. Dies ist schematisch dadurch angedeutet, dass die an die Schutzschicht 2 in Fig. 1 angrenzende Schicht gegenüber der entsprechenden inneren Schicht des Schichtsystems 3 eine geringere Dicke aufweist. Die Beschichtungsraten sind aufgrund des grösseren Abstandes der konkaven Linsenseite zum Target um ca. 10 % kleiner.

Die Beschichtungszeiten betragen für die Schichten von innen nach aussen beispielsweise: 1. 32 s, 2. 27 s, 3. 79 s, 4. 126 s.

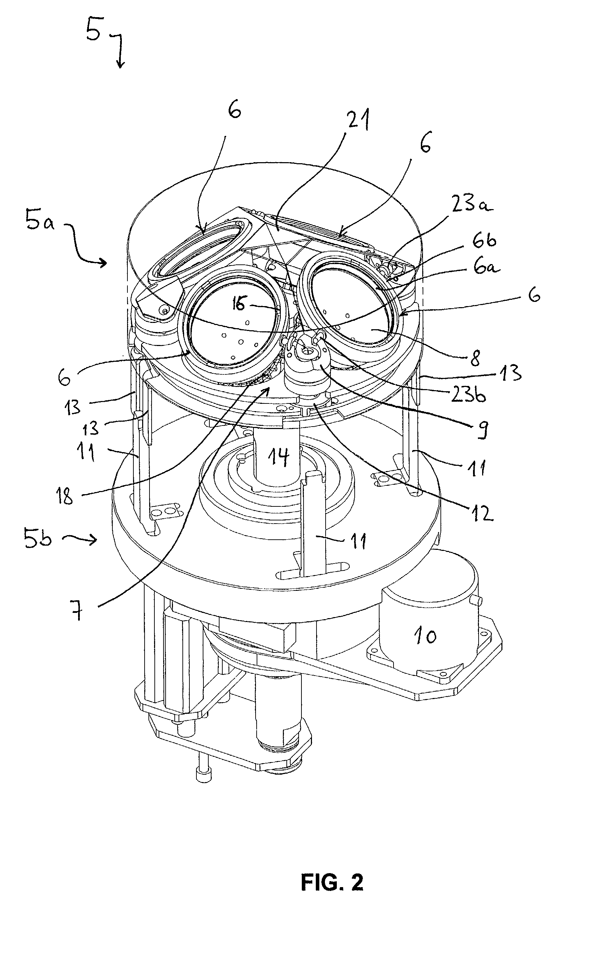

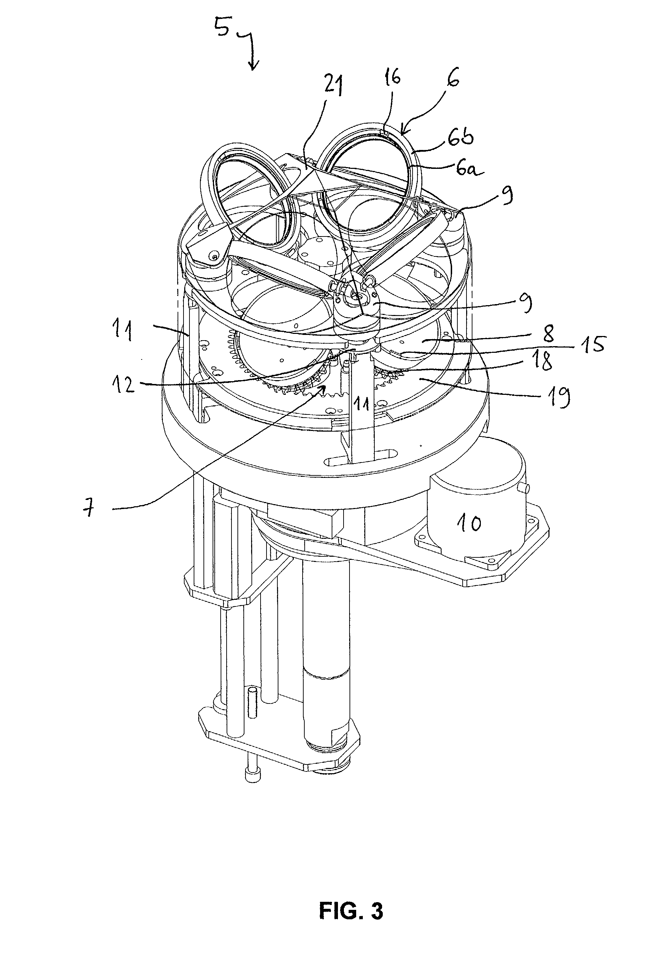

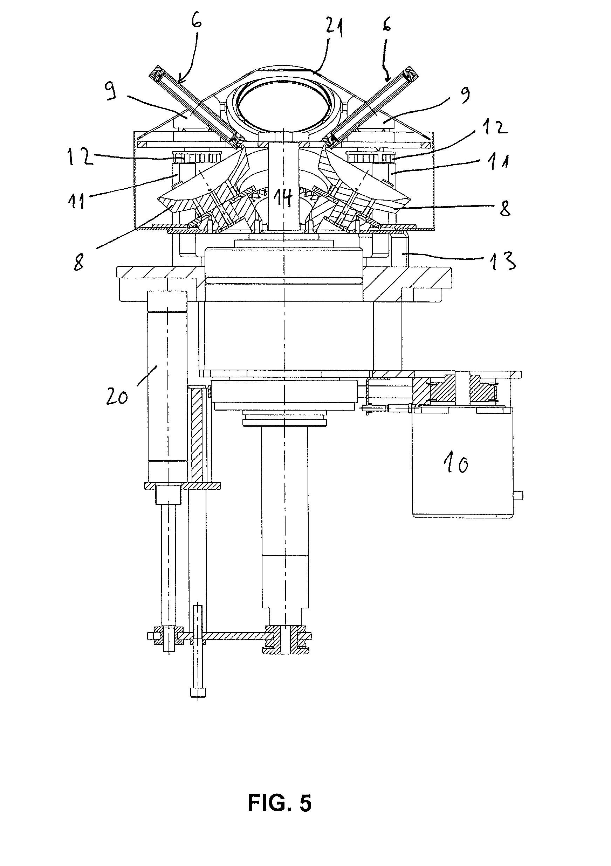

In den Figuren 2-5 ist ein Substrathalter 5 als Kernstück einer erfindungsgemässen Vorrichtung dargestellt. Neben dem erfindungsgemässen Beschichtungsverfahren kann er bei sämtlichen Beschichtungsvorgängen eingesetzt werden, bei denen ein Substrat im Vakuum sowohl gedreht als auch gewendet werden muss.

Der Substrathalter 5 umfasst vier ringförmige Aufnahmeelemente 6, in die das Substrat, beispielsweise ein Brillenglas, so eingesetzt werden kann, dass seine Hauptoberflächen bzw. die Vorder- und Rückseite zugänglich sind. Die Aufnahmeelemente 6 bestehen aus einem inneren Ring 6a und einem äusseren Ring 6b, die relativ zueinander verdrehbar sind. Der innere Ring 6a weist Nocken 16 auf, mit denen er in Drehung relativ zum äusseren Ring versetzt werden kann. Der äussere Ring 6b weist an seinem Umfang zwei Stifte 23a, 23b auf, mit denen er in der Abdeckung 21 des Substrathalters 5 gelagert ist. Die Stifte 23a, 23b definieren die Wendeachse. Einer der Stifte 23a ist mit einem Ankopplungselement 22, z.B. einem Zahnrad, versehen und wirkt mit einem Wendeantrieb 9 zusammen (siehe unten).

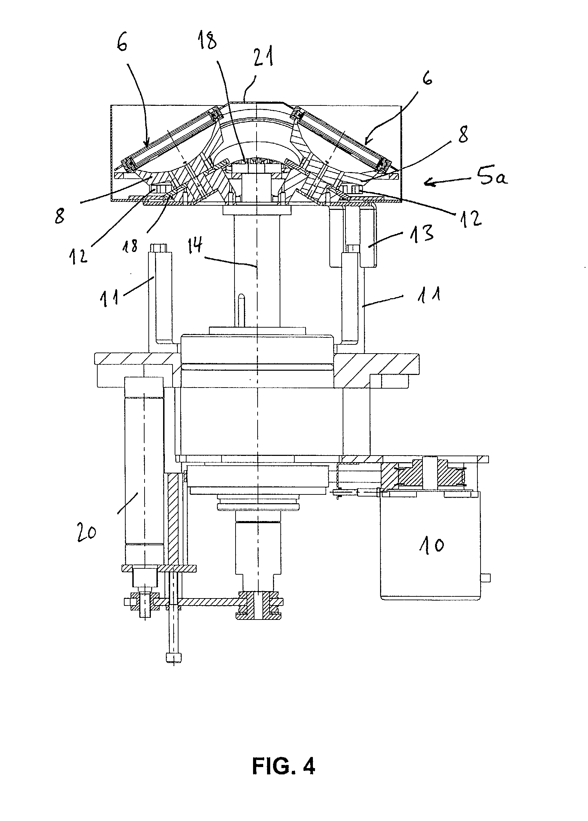

Die Aufnahmeelemente 6 liegen in der Arbeitsposition (Fig. 2 und 4) auf Aufnahmeschalen 8 auf. Diese sind Teil eines Planetengetriebes 7 und werden durch einen Antrieb 10 in eine Drehbewegung versetzt. Diese Bewegung wird durch den Nocken 16 am inneren Ring 6a und Nocken 15 an den den Aufnahmeschalen 8 auf den inneren Ring 6a der Aufnahmeelemente 6 übertragen. Das Planetengetriebe 7 wird angetrieben, indem eine mit den Aufnahmeschalen 8 gekoppelte Welle 14 durch den Antrieb 10 gedreht wird. Die Aufnahmeschalen 8 sind um ihre Längsachse drehbar und werden gedreht, indem bei der Rotation der Welle Zahnkränze 18 an den Aufnahmeschalen 8 an einem nicht mitdrehenden äusseren Planetenrad 19 abrollen. Das äussere Planetenrad 19 wird festgehalten, indem es wenigstens mittelbar mit nach unten ragenden Kulissen 13 verbunden ist, mit denen ein drehfest am unteren Teil 5b des Substrathalters 5 angeordneter Schaltzapfen 11 zusammenwirkt. Durch einen Hubzylinder 20 ist der obere Teil 5a des Substrathalters 5 relativ zum unteren Teil 5b verschiebbar.

In der Arbeitsposition ist der Abstand derart, dass zwar die Schaltzapfen 11 mit der Kulisse 13 zusammenwirken, so dass das Planetengetriebe in Gang gesetzt wird, jedoch die Schaltzapfen 11 nicht bis in den Bereich der äusseren Planetenscheibe 19 ragen. Damit werden die Aufnahmeelemente 6 in der Arbeitsposition wie beschrieben um eine durch ihren Mittelpunkt verlaufende Drehachse gedreht.

Zum Wenden der Aufnahmeelemente wird der Abstand zwischen dem oberen und dem unteren Teil 5a, 5b verringert. Die Schaltzapfen 11 greifen nun in den oberen Teil 5a ein und drücken dessen Abdeckung 21, in der die Aufnahmeelemente 6 gelagert sind, nach oben. Die Aufnahmeelemente 6 werden so aus den Aufnahmeschalen 8 gehoben und nicht weiter gedreht. In dieser Stellung sind die Ankopplungselemente 22 der Aufnahmeelemente 6 sind im Eingriff mit jeweils einem Wendeantrieb 9. Dieser ist mit jeweils einem Schaltteller 12 verbunden. Indem der Schaltzapfen 11 in der Wendeposition (geringer Abstand der Teile 5a, 5b) bei Rotation der Welle und damit der Wendeantriebe 9 um die Wellenlängsachse periodisch gegen die Schaltteller 12 bzw. einen daran angeordneten Nocken stösst, wird der Wendeantrieb in eine Drehbewegung um seine eigene Längsachse versetzt. Diese Drehbewegung wird durch das Ankopplungselement 22 in die Wendebewegung der Aufnahmeelemente 6 umgesetzt.

Im Anwendungsfall befinden sich im wesentlichen nur der obere Teil 5a und die Schaltzapfen 11 innerhalb der Sputterkammer. Durch den gemeinsamen Antrieb 10 muss lediglich eine Durchführung gegeneinander beweglicher Bauteile, hier die Welle 14 und die sie umgebenden Hülsen, aus der Vakuumkammer realisiert und abgedichtet werden.

Mit dem beschriebenen Substrathalter 5 lässt sich das erfindungsgemässe Verfahren schnell und ohne zwischenzeitliches Belüften durchführen. Indem mehrere Substrate gleichzeitig beschichtet und gewendet werden können, lässt sich ein hoher Durchsatz erzielen.

## Patentansprüche

1. Verfahren zur Herstellung eines optisch wirksamen Schichtsystems (3) auf einem Substrat (1) mit einer Vorderseite (1a) und einer Rückseite (1b) durch plasmaunterstütztes Zerstäuben eines Festkörpertargets (Sputtern), **dadurch gekennzeichnet, dass** auf der Rückseite (1b) des Substrats (1) eine Schutzschicht (2) und anschliessend auf der Vorderseite (1a) des Substrats das Schichtsystem (3) aufgesputtert wird.

2. Verfahren nach Anspruch 1, **dadurch gekennzeichnet, dass** nach der Herstellung des Schichtsystems (3) auf der Vorderseite (1a) ein weiteres Schichtsystem (4) auf der Rückseite (1b) aufgesputtert wird.

3. Verfahren nach Anspruch 2, **dadurch gekennzeichnet, dass** die Schutzschicht (2) derart hergestellt wird, dass ihre optischen Eigenschaften an die durch das weitere Schichtsystem (4) zu erfüllenden Vorgaben angepasst sind.

4. Verfahren nach einem der vorangegangenen Ansprüche, **dadurch gekennzeichnet, dass** die Schutzschicht (2) unter Verwendung eines im wesentlichen sauerstofffreien Plasmas aufgesputtert wird.

5. Verfahren nach einem der vorangegangenen Ansprüche, **dadurch gekennzeichnet, dass** die Schutzschicht (2) unter Verwendung desselben Targets hergestellt wird, das auch zur Herstellung wenigstens einzelner Schichten des Schichtsystems (3, 4) dient.

6. Verfahren nach Anspruch 5, **dadurch gekennzeichnet, dass** zur Herstellung der Schutzschicht (2) und der Schichten des Schichtsystems (3, 4) dasselbe Target verwendet wird, wobei das Prozessgas zur Herstellung des Plasmas in Abhängigkeit von der herzustellenden Schicht ausgetauscht wird.

7. Verfahren nach einem der vorangegangenen Ansprüche, **dadurch gekennzeichnet, dass** die Schutzschicht (2) aus Siliziumoxid, Siliziumnitrid, Aluminiumoxid und/oder Aluminiumnitrid besteht.

8. Verfahren nach einem der vorangegangenen Ansprüche, **dadurch gekennzeichnet, dass** die Schutzschicht (2) mit einer Dicke von 10 bis 40 nm aufgetragen wird.

9. Verfahren nach einem der vorangegangenen Ansprüche, **dadurch gekennzeichnet, dass** das Material der Schutzschicht (2) und ihre Dicke in Abhängigkeit von den Prozessparametern beim Auftragen des Schichtsystems (3) auf der Vorderseite (1a) so gewählt werden, dass nach dem Auftragen dieses Schichtsystems (3) eine Schutzschicht (2) mit einer vorbestimmten Dicke vorhanden ist.

10. Vorrichtung zur Durchführung des Verfahrens nach einem der vorangegangenen Ansprüche mit einer evakuierbaren Sputterkammer und einem Substrathalter (5) mit Aufnahmeelementen (6) für Substrate (1), mit denen die Substrate (1) sowohl um eine im wesentlichen parallel zur Substratfläche orientierte Wendeachse als auch um eine im wesentlichen senkrecht zur Substratfläche orientierte Drehachse drehbar sind.

11. Vorrichtung nach Anspruch 10, **dadurch gekennzeichnet, dass** ein gemeinsamer Antrieb (10) für die Drehbewegung und die Wendebewegung vorhanden ist.
